# EUROPEAN PATENT APPLICATION

(11) **EP 2 377 681 A1**
(43) Date of publication of application: **19.10.2011**
(21) Application number: 11159303.4
(22) Date of filing: 23.03.2011
(51) Int. Cl.: B32B 7/02, B32B 7/12, B29C 61/02, B29C 53/32, B32B 27/08, B32B 1/00, C09J 7/02

(54) **Film and Adhesive/Bonding Sheet**

(30) Priority: 19.04.2010 JP 2010096173
(71) Applicant: NITTO DENKO CORPORATION, Ibaraki-shi, Osaka 567-8680 (JP)
(72) Inventor: Nishio, Akinori, Ibaraki-shi Osaka 567-8680 (JP)
(74) Representative: Grünecker, Kinkeldey, Stockmair & Schwanhäusser

(57) **Abstract**

When a film that is fixed to a surface of an adherend by means such as adhesion and rolled into a cylinder by heating is grasped by a grasping tool or adhered to a holder in order to remove the film from the surface of the adherend, the grasping tool or holder applies a force to the rolled film to urge the film toward the surface of the adherend. If the rolled film is pressed flat by the force, the area of contact between the film and the adherend increases and so does the strength of adhesion between them. Consequently, the film needs to be re-grasped or reattached to the holder or a larger force is required in order to peel the rolled film off the adherend. To solve the problem, there is provided a film that includes a thermally shrinkable base material, an adhesive resin layer and a non-thermally shrinkable base material stacked in sequence and has the property of rolling up into a cylindrical roll by heating and not automatically returning to the original shape after the change into the cylindrical roll.

## Description

### BACKGROUND OF THE INVENTION

### Field of the Invention

The present invention relates to a film that changes its shape to a cylindrical roll by heating and maintains the cylindrical shape and an adhesive/bonding sheet that uses the film.

### Description of the Related Art

The present inventors have developed an easily peelable adhesive/bonding sheet that has as a base material a laminate including a thermally shrinkable film layer, an adhesive resin layer (adhesive/bond layer), and a rigid resin film layer (Japanese Patent Application No. 2009-041200 and Japanese Patent No. 4151850).
The tape is characterized in that contraction stress caused by heating of the base material is converted to torque in the laminate so that the adhesive sheet can be peeled off an adherend as if the sheet is peeled by hand. The peeled tape takes on a cylindrical shape.
In order for the tape to be practically useful, the cylindrical rolled tape needs to be readily removable, more specifically, the peeled tape needs to maintain the cylindrical shape after peeling. This is because if the cylindrical shape is easily changed by stress caused by a removing operation in a practically useful method for removing the cylindrically rolled tape, such as removal using a peeling tape, picking up with a robotic arm or the like, or blowing off by air (Japanese Patent Application No. 2009-200231), the adhesive/bonding sheet can reattach to the adherend and become difficult to remove.

A problem to be solved by the invention will be described below. When a film that was fixed to the surface of an adherend by means such as adhesion and rolled into a cylinder by heating is grasped by a grasping tool or is attached to a holder in order to remove the film from the surface of the adherend, the grasping tool or the holder can apply a force to the film to urge the film toward the surface of the adherend.
In that case, the film changed into the cylindricall rool is pressed flat by the force, the area of contact between the film and the adherend increases and so does the strength of adhesion between them naturally. Consequently, the film needs to be re-grasped or reattached to the holder to remove the rolled film from the adherend or a greater force needs to be applied to peel the film.
Accordingly, a great force will be required to remove the rolled film from the surface of the adherend.
To avoid the situation, the strength of the cylindrical rolled film needs to be increased so that when the film is grasped with the grasping tool or attached to the holder, a force applied to the cylindrically rolled film by the grasping tool or the holder to urge the film toward the adherend needs to be prevented from changing the cylindrical structure to the extent that the area of contact between the film and the adherend affects peeling/removal.

### SUMMARY OF THE INVENTION

The present inventors have diligently investigated the problem described above and have invented films and adhesive/bonding sheets described below.
A film including, a thermally shrinkable base material, an adhesive resin layer, and a non-thermally shrinkable base material stacked in sequence, wherein the film has the property of changing its shape into a cylindrical roll by heating and not automatically returning to an original shape after the change into the cylindrical roll (claim 1); the film according to claim 1, wherein the thermally shrinkable base material is a stretched material selected from the group consisting of polyesters, polyolefins, and polyamides and the non-thermally shrinkable base material is a material having thermal dimensional stability improved by processing such as stretching orientation fixing, the non-thermally shrinkable material being selected from the group consisting of polyesters, polyolefins, polyimides and polyamides (claim 2); the film according to claim 1 or 2, wherein the thermally shrinkable base material exhibits a Young's modulus multiplied by thickness of the thermally shrinkable base material equal to or higher than 42000 N/m at room temperature (claim 3); the film according to claim 2, wherein the thermally shrinkable base material is a polyethylene terephthalate film or a polybutylene phthalate film subjected to stretching and the non-thermally shrinkable base material is a polyethylene terephthalate resin film subjected to thermal dimensional stability improving processing (claim 4); the film according to any one of claims 1 to 4, wherein the adhesive resin layer is made of an adhesive including a polymer polymerized from an acrylic monomer or a bond including a polyester polyol (claim 5); an adhesive/bonding sheet comprising an adhesive/bond layer provided on a surface of the non-thermally shrinkable base material of the film according to any one of claims 1 to 5 for adhering to any adherend (claim 6); and a film or adhesive/bonding sheet according to any one of claims 1 to 6, wherein the external force required for returning the film or adhesive/bonding sheet cut into a piece of 50 × 20 mm that has changed into a cylindrical roll by heating to its original shape is greater than or equal to 0.01 N (claim 7).

According to the present invention, an adhesive/bond layer is disposed on a film to make an adhesive/bonding sheet. When the adhesive/bonding sheet is used as a surface protection tape during dicing of a wafer, for example, the adhesive/bonding sheet cut in the dicing peels off the wafer or the like from an end and rolls into a cylinder by subsequent heating. Then, when the adhesive/bonding sheet is peeled and removed, the cylindrical roll is pressed against the wafer by a peeling/removal tool or an adhesive sheet for peering/removal.
The cylindrical roll is not pressed flat more than necessary under such pressure and the peeled adhesive/bonding sheet does not reattach to the wafer to make peeling/removal difficult. Furthermore, even if the adhesive/bonding sheet, which has been peeled off, reattaches to the wafer, the adhesive/bonding sheet can quickly return to the previous, cylindrical shape because the film itself has a certain degree of rigidity. Therefore the peeling/removal of the cylindrically rolled sheet can be smoothly continued.

### BRIEF DESCRIPTION OF THE DRAWINGS

FIG. 1 is a cross-sectional view of a film of the present invention;
FIG. 2 is a cross-sectional view of an adhesive/bonding sheet of the present invention;
FIG. 3 is a diagram illustrating how the film and adhesive/bonding sheet of the present invention roll up;

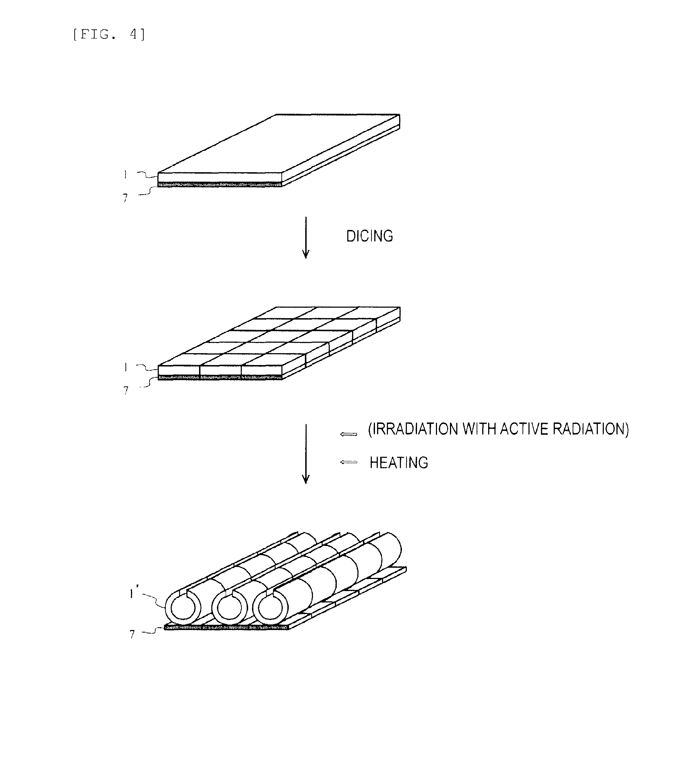

FIG. 4 is a diagram illustrating how the adhesive/bonding sheet of the present invention used as a surface protection sheet for dicing rolls up;
FIG. 5 is a conceptual diagram illustrating roll-out of the cylindrically rolled sheet;
FIG. 6 is a diagram illustrating a method for measuring a required load in test 1;
FIG. 7 is a diagram illustrating a method for measuring a required load in tests 2 and 3; and
FIG. 8 is a diagram illustrating steps of removing a cylindrically rolled sheet in test 4.

### DETAILED DESCRIPTION OF THE PREFERRED EMBODIMENTS

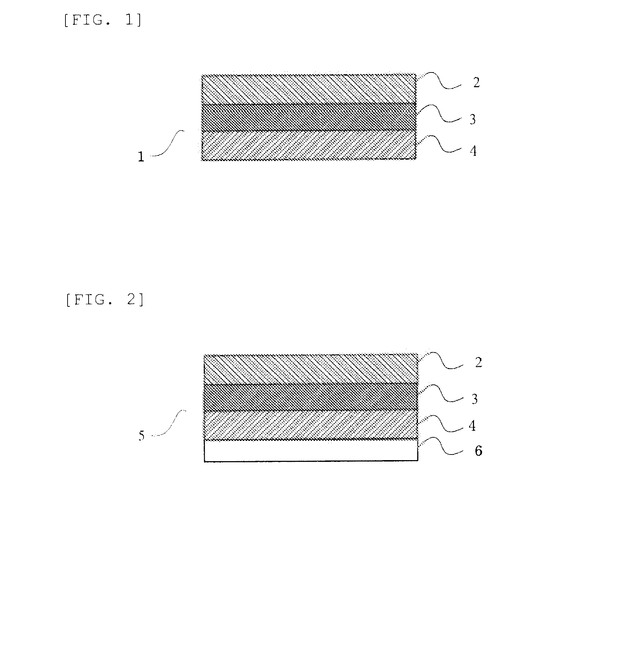

The present invention will be described below with reference to drawings. FIG. 1 is a cross-sectional view of a film of the present invention. FIG. 2 is a cross-sectional view of an adhesive/bonding sheet of the present invention. The film 1 illustrated in FIG. 1 is a laminated film made of a thermally shrinkable base material 2 and a non-thermally shrinkable base material 4 which constrains shrinkage of the thermally shrinkable base material 2, that are laminated together with an adhesive resin layer 3. The adhesive/bonding sheet 5 illustrated in FIG. 2 is a laminated film including an adhesive/bond layer 6 stacked on the non-thermally shrinkable base material 4 of the film illustrated in FIG. 1. In this case, the film 1 functions as a base material that supports the adhesive/bonding sheet 5.

The thermally shrinkable base material 2 may be a film layer that is shrinkable along at least one axis and may be a film that shrinks by heating, light or electrical stimulation. It is preferable in view of working efficiency that the thermally shrinkable base material 2 be a film that shrinks by heat. The thermally shrinkable base material 2 may be shrinkable along only one axis or may be shrinkable primarily in a certain direction (along one axis) and secondarily in a different direction (for example, in the direction perpendicular to the primary direction). The thermally shrinkable base material 2 may be a single layer or a multilayer of two or more layers.

The rate of shrinkage of the shrinkable film of the thermally shrinkable base material 2 in the primary shrinkage direction is preferably 30 to 90%. If the thermally shrinkable base material 2 is a thermally shrinkable film, the rate of the shrinkage of the thermally shrinkable film in the primary shrinkage direction is preferably 30 to 90% at a predetermined temperature in the range of 70 to 180°C (for example 95°C or 140°C). The rate of shrinkage of the shrinkable film of the thermally shrinkable base material 2 in directions other than the primary shrinkage direction is preferably less than or equal to 10%, more preferably less than or equal to 5%, particularly preferably less than or equal to 3%. The thermal-shrinkability of the thermally shrinkable film can be imparted by stretching the film extruded with an extruding machine, for example.

The thermally shrinkable film may be uniaxially-stretched film made of one or more resins selected from the group consisting of polyester such as polyethylene terephthalate, polyolefin such as polyethylene and polypropylene, polynorbornene, polyimide, polyamide, polyurethane, polystyrene, polyvinylidene chloride, and polyvinyl chloride. Particularly preferable is a uniaxially-stretched film of a polyolefin resin (including cyclic polyolefin resin) such as polyester resin, polyethylene, polypropylene, and polynorbornene or polyurethane resin because of good coating workability of an adhesive/bonding agent. Such a thermally shrinkable film may be a commercially available film such as "SPACECLEAN" from Toyobo Co., Ltd., "Fancy wrap" from Gunze Plastic Film Company, "TORAYFAN" from Toray Co., Ltd., "LUMIRROR" from Toray Co., Ltd., "ARTON" from JSR Corporation, "ZEONOR" from Zeon Corporation, and "Suntec" from Asahi Kasei Chemicals.

If the adhesive/bonding sheet 5 is of radiation curable type and the film 1 is used as the base material for supporting the adhesive/bonding sheet 5, the thermally shrinkable base material 2 needs to be a material capable of transmitting a predetermined amount of radiation or more (for example a material such as a transparent resin) when the radiation curable adhesive layer is hardened by irradiating with radiation through the thermally shrinkable base material 2.

The thermally shrinkable base material 2 is typically 5 to 300 µm thick, preferably 10 to 100 µm thick. If the thermally shrinkable base material 2 is too thick, the thermally shrinkable base material 2 will be too rigid to change into a cylindrical roll and tends to separate from the non-thermally shrinkable base material 4, which can lead to film breakage. It is known that too rigid a film exhibits a large elastic deformation due to stress remaining after the tape was bonded to a wafer and tends to warp significantly if the wafer is thin. Commonly used surface finishing, for example chemical or physical treatment such as chromic acid treatment, exposure to ozone, flame or high-voltage electric shock, or ionizing radiation treatment, or coating with a primer (for example an adhesive substance) may be applied to the surface of the thermally shrinkable base material 2 in order to enhance adhesion to and retention of an adjacent layer.

The non-thermally shrinkable base material 4 constrains shrinkage of the thermally shrinkable base material 2 to produce a counteracting force, which allows the entire film to produce a couple that drives rolling. The non-thermally shrinkable base material 4 also can suppress secondary shrinkage of the thermally shrinkable base material in a direction different from the primary shrinkage direction and therefore can cause the thermally shrinkable base material 2, which is uniaxially shrinkable but does not necessarily shrinks in only one uniform direction, to shrink in a converged single direction. Accordingly, when a stimulus such as heat is applied to the film 1 to facilitate shrinkage of the thermally shrinkable base material 2, the repulsion in the non-thermally shrinkable base material 4 against the shrinkage force of the thermally shrinkable base material 2 can act as a driving force to lift an edge or edges (one end or two opposing ends) of the film 1, so that the film 1 automatically rolls from the edge or edges in one direction or toward the center (normally along the primary shrinkage axis of the thermally shrinkable film) into a cylinder with the thermally shrinkable base material 2 being inside. The non-thermally shrinkable base material 4 also can prevent a shear force caused by the shrinkage deformation of the thermally shrinkable base material 2 from being transmitted to the adhesive/bond layer 6 and the adherend. Consequently, damage to the adhesive/bond layer 6 (for example, a cured adhesive/bond layer) with reduced adhesion at the time of repeeling, damage to the adherend, and a stain on the adherend during removal can be prevented.

The non-thermally shrinkable base material 4 has an elastic bonding property (including an adherence property) in order to exhibit a function of constraining shrinkage of the thermally shrinkable base material 2. The non-thermally shrinkable base material 4 is preferably stiff or rigid to some extent so as to smoothly form a cylindrical roll. The non-thermally shrinkable base material 4 may be a single layer or a multiplayer in which different layers have the different functions.

In the examples in FIGS. 1 and 2, the adhesive resin layer 3 is non-thermally shrinkable, like the non-thermally shrinkable base material 4.
The adhesive resin layer 3 is preferably deformable, that is, in a rubber state, at the shrinkage temperature of the thermally shrinkable base material 2 (or, if the film 1 is used as the base material for supporting a self-rolling adhesive/bonding sheet, at the peeling temperature of the self-rolling adhesive/bonding sheet). However, a fluid material does not exhibit a sufficient counteracting force, eventually the shrinkable film alone shrinks and deformation (self-rolling) cannot be caused. Therefore, the adhesive resin layer 3 is preferably made of a resin that is three-dimensionally cross linked to reduce fluidity. The thickness of the adhesive resin layer 3 resists weaker components of nonuniform shrinkage forces of the thermally shrinkable base material 2 to prevent shrinkage deformation due to the weaker components, thereby directing the weaker component forces in the uniform shrinkage direction. Warpage after wafer grinding can be caused probably by elastic deformation of the shrinkable film due to stress remaining after bonding of the adhesive/bonding sheet to the wafer. The adhesive resin layer 3 also relaxes the remaining stress to reduce the warpage.

Accordingly, the adhesive resin layer 3 is made of an adhesive resin that has a glass transition temperature of for example 50°C or lower, preferably room temperature (25°C) or lower, more preferably 0°C or lower. The adhesivity of the surface of the adhesive resin layer 3 on the thermally shrinkable base material 2 side is preferably 0.5 N/10 mm or greater when measured in a peeling test at an angle of 180° (compliant with JIS Z0237, at a peeling rate of 300 mm/minute at a temperature of 50°C). If the adhesivity is too low, the thermally shrinkable base material 2 and adhesive resin layer 3 tend to peel off from each other.

The shear elasticity G of the adhesive resin layer 3 is preferably 1 × 10⁴ Pa to 5 × 10⁶ Pa (particularly preferably 0.05 × 10⁶ Pa to 3 × 10⁶ Pa) at a temperature in the range from room temperature to peeling temperature (for example 80°C).
If the shear elasticity is too low, the effect of converting the contraction stress in the thermally shrinkable base material 2 to stress required for rolling will be low; on the other hand, if the shear elasticity is too high, the rigidity will be high and therefore the rolling capability will be poor. In addition, a rigid material in general exhibits poor adhesion, is likely to make it difficult to make a film, and has a poor effect of relaxing remaining stress. The thickness of the adhesive resin layer 3 is preferably approximately in the range of 15 to 150 µm. If the adhesive resin layer 3 is too thin, the adhesive resin layer 3 will have a week constraint on the shrinkage of the thermally shrinkable base material 2 and a poor effect of relaxing stress. On the other hand, if the adhesive resin layer 3 is too thick, the adhesive resin layer 3 will have a poor capability of changing its shape to a cylindrical roll, will be hard to work and economically inefficient. Therefore, the shear elasticity G of the adhesive resin layer 3 (for example the shear elasticity at 80°C) multiplied by the thickness of the adhesive resin layer 3 (shear elasticity G × thickness) is preferably 1 to 1000 N/m (more preferably 1 to 150 N/m, more preferably 1.2 to 100 N/m) .

The adhesive resin layer 3 is preferably made of a material that has a high radiation transmittance if the adhesive/bond layer 6 is made of a radiation curable adhesive material. From the view point of manufacture and workability, the adhesive resin layer 3 is preferably made of a material the thickness of which can be chosen as appropriate and which is pliable and easily formable into a film.

The adhesive resin layer 3 may be made of a foam material (foam film) such as urethane foam or acrylic foam that has a surface (at least the surface on the thermally shrinkable base material 2 side) applied with an adhesive, or a non-foam resin film made of a material such as rubber or thermoplastic elastomer. The adhesive applied is not limited to any specific one. For example, one of known adhesive such as an acrylic adhesive, rubber adhesive, a vinyl alkyl ether adhesive, a silicone adhesive, a polyester adhesive, a polyamide adhesive, a urethane adhesive, a styrene-diene block copolymer adhesive, or any combination of these may be used. In particular, an acrylic adhesive is preferable because of its good controllability of adhesion. The adhesive resin applied and the resin of the foam film or non-foam resin film are preferably of the same type for the reason of high compatibility. For example, if an acrylic adhesive is used in the adhesive treatment, acrylic form is preferable as the resin film.

The adhesive resin layer 3 may be made of a resin composition that is adhesive in itself, such as a cross-linked acrylic adhesive. The layer made of an adhesive material such as cross-linked acrylic adhesive (adhesive layer) can be made using a relatively simple method without needing an extra adhesive treatment and therefore preferable because of good productivity and economy.

The cross-linked acrylic adhesive has a composition in which a cross-linking agent is added to an acrylic polymer-based acrylic adhesive. For example, the acrylic polymer may be: a homopolymer or copolymer of alkyl (meth)acrylate ester such as C₁-C₂₀ alkyl acrylate ester such as methyl (meth)acrylate, ethyl (meth)acrylate, butyl (meth)acrylate, 2-ethylhexyl (meth)acrylate, and octyl (meth)acrylate; and a copolymer of the alkyl (meth)acrylate ester and other copolymerized monomer [for example a carboxyl group- or acid anhydride group-containing monomer such as acrylic acid, methacrylic acid, itaconic acid, fumaric acid, and maleic anhydride; a hydroxyl group-containing monomer such as 2-hydroxyethyl (meth)acrylate; an amino group-containing monomer such as morpholiyl (meth)acrylate; an amido group-containing monomer such as (meth)acrylamide; a cyano group-containing monomer such as (meth)acrylonitrile; (meth)acrylic acid ester including an alicyclic hydrocarbon group such as isobornyl (meth)acrylate].

The acrylic polymer is preferably a copolymer of one or more of C₁-C₁₂ alkyl (meth)acrylate ester such as ethyl acrylate, butyl acrylate, and 2-ethylhexyl acrylate and at least one copolymerized monomer selected from the group consisting of a hydroxyl group-containing monomer such as 2-hydroxyethyl acrylate and a carboxyl group- or acid anhydride group-containing monomer such as acrylic acid, or a copolymer of one or more of C₁-C₁₂ alkyl (meth)acrylate ester, alicyclic hydrocarbon group-containing (meth)acrylate ester and at least one copolymerized monomer selected from the group consisting of hydroxyl group-containing monomer and carboxyl group- or acid anhydride group-containing monomer.

The acrylic polymer can be a high-viscosity liquid prepolymer prepared using solventless photo (such as ultraviolet) polymerization of any of the monomers enumerated above (and a polymerization initiator). Then, a cross-linking agent can be added to the prepolymer to produce a cross-linked acrylic adhesive composition. The cross-linking agent may be added during production of the prepolymer. Alternatively, a cross-linking agent and a solvent (which is not necessarily required if an acrylic polymer solution is used) can be added to an acrylic polymer or its solution produced by polymerization of any of the monomers enumerated above to produce the cross-linked acrylic adhesive composition.

The cross-linking agent is not limited to any specific one. For example, an isocyanate cross-linking agent, a melamine cross-linking agent, an epoxy cross-linking agent, an acrylate cross-linking agent (polyfunctional acrylate), or an isocyanate group-containing (meth)acrylate ester can be used. Examples of the acrylate cross-linking agent include: hexane diol diacrylate, 1,4-butane diol diacrylate, trimethylol propane triacrylate, pentaerythritol tetraacrylate, and dipentaerythritol hexa-acrylate. Examples of the isocyanate group-containing (meth)acrylate ester include: 2-isocyanato ethyl acrylate and 2-isocyanato ethyl methacrylate. An acrylate cross-linking agent (polyfunctional acrylate) and a UV-reactive cross-linking agent such as isocyanate group-containing (meth)acrylate ester are particularly preferable. The amount of the cross-linking agent to be added is typically 0.01 to 15 pts.wt., preferably 0.05 to 12 pts.wt., for 100 pts.wt. of the aforementioned base polymer.

The cross-linking acrylic adhesive may contain, in addition to the base polymer and the cross-linking agent, any of appropriate additives such as a cross-linking promoter, a tackifier (for example rosin derivative resin, polyterpene resin, petroleum resin, or oil phenol resin), thickener, plasticizer, filler, anti-aging agent, and antioxidizing agent.

A cross-linked acrylic adhesive layer as the adhesive resin layer 3 that fits the purpose of using the sheet can be made simply by forming a cross-linked acrylic adhesive composition in which a cross-linking agent is added to the prepolymer into a film having a desired thickness and area using a known method such as casting and then re-irradiating the film with light to promote cross-linking reaction (and polymerization of unreacted monomers). The adhesive resin layer (cross-linked acrylic adhesive layer) thus produced is self-adhesive and therefore can be directly bonded between the thermally shrinkable base material 2 layer and the non-thermally shrinkable base material 4 layer. The cross-liked acrylic adhesive layer may be a commercially available double-faced adhesive tape such as the one available from Nitto Denko Corporation under the trade designation "HJ-9150W". After the adhesive film is bonded between the thermally shrinkable base material 2 layer and the non-thermally shrinkable base material 4 layer, the film may be re-irradiated with light to cause cross-linking reaction.

Alternatively, the cross-linked acrylic adhesive layer as the adhesive resin layer 3 can be made by applying a cross-linked acrylic adhesive composition in which the acrylic polymer and the cross-linking agent are dissolved in a solvent to the surface of the non-thermally shrinkable base material 4, bonding the thermally shrinkable base material 2 on top of it, then irradiating with light. If the adhesive/bond layer 6 is radiation curable, the cross-linked acrylic adhesive may be cured (cross-linked) under irradiation with radiation (light) for curing of the adhesive/bond layer 6 during removal.

The adhesive resin layer 3 in the present invention may further contain beads such as glass or resin beads. Addition of glass or resin beads advantageously facilitates control of the adhesion and shear elasticity of the adhesive resin layer 3. The average diameter of the beads is for example 1 to 100 µm, preferably about 1 to 20 µm. The quantity of beads added is for example 0.1 to 10 pts.wt., preferably 1 to 4 pts.wt., for 100 pts.wt. of the entire adhesive resin layer 3. A quantity of added beads in the ranges given above sufficiently produces the effect described above without reducing the adhesion.

By imparting rigidity or stiffness to the non-thermally shrinkable base material 4, functions are provided that produce a counteracting force against the shrinkage force of the thermally shrinkable base material 2 and therefore a couple required for rolling. The provision of the non-thermally shrinkable base material 4 allows the laminated sheet or adhesive/bonding sheet to smoothly automatically roll up into a neat cylindrical roll without stopping halfway or rolling in a wrong direction when a stimulus such as heat that triggers shrinkage is applied to the thermally shrinkable base material 2.

The film of the non-thermally shrinkable base material 4 may be a film made of one or more resins selected from the group consisting of: polyester such as polyethylene terephthalate, polybutylene terephthalate and polyethylene naphthalate; polyolefin such as polyethylene and polypropylene; polyimide; polyamide; polyurethane; styrene resin such as polystyrene; polyvinylidene chloride; and polyvinyl chloride. Particularly preferable is a polyester resin film, a polypropylene film, and a polyamide film because of good coating workability of an adhesive/bonding agent. The non-thermally shrinkable base material 4 may be a single layer or multilayer including two or more stacked layers. The film of the non-thermally shrinkable base material 4 is substantially unshrinkable; the shrinkage rate is for example less than or equal to 5%, preferably less than or equal to 3%, more preferably less than or equal to 1%.

The Young's modulus of the non-thermally shrinkable base material 4 multiplied by the thickness of the non-thermally shrinkable base material 4 (Young's modulus × thickness) is preferably 3.0 × 10⁵ N/m or less (for example 1.0 × 10² to 3.0 × 10⁵ N/m), more preferably 2.8 × 10⁵ N/m or less (for example 1.0 × 10³ to 2.8 × 10⁵ N/m) at the peeling temperature (for example 80°C). If the Young's modulus multiplied by the thickness of the non-thermally shrinkable base material 4 falls within any of the ranges given above, contraction stress in the thermally shrinkable base material 2 can be converted to rolling stress, the shrinkage directions of the thermally shrinkable base material 2 can be converged into one, and rolling is not inhibited by rigidity. The Young's modulus of the non-thermally shrinkable base material 4 at peeling temperature (for example 80°C) is preferably 3 × 10⁶ to 2 × 10¹⁰ N/m², more preferably 1 × 10⁸ to 1 × 10¹⁰ N/m². If the Young's modulus is in any of these ranges, a neat cylindrical roll can be readily formed. The thickness of the non-thermally shrinkable base material 4 is for example 20 to 150 µm, preferably 25 to 95 µm, more preferably 30 to 90 µm, particularly preferably 30 to 80 µm or so. A thickness in any of these ranges facilitates formation of a neat cylindrical roll, does not reduce the self-rolling capability, and provides good workability and economic efficiency.

The adhesive/bond layer 6 may be an adhesive layer intrinsically having a low adhesivity or a bond layer intrinsically having a low bonding strength. However, the adhesive/bond layer 6 is preferably a removable adhesive layer having an adhesivity that is high enough to adhere to an adherend but can be reduced or eliminated by using some method (adhesion reduction processing) after an intended role is fulfilled. Such a removable adhesive layer can be formed in the same way as an adhesive layer of a known removable adhesive/bonding sheet. For the purpose of self-rolling, the adhesivity (180°-peeling on a silicon mirror wafer at a pulling rate of 300 mm/minute) of the adhesive layer or the adhesive layer subjected to adhesion reduction processing is preferably less than or equal to 6.5 N/10 mm (particularly preferably less than or equal to 6.0 N/10 mm) at room temperature (25°C), for example.

The adhesive/bond layer 6 is particularly preferably a radiation curable adhesive layer. The radiation curable adhesive layer can be made of a material that is adhesive initially but forms a three-dimensional network to exhibit high elasticity after irradiation with radiation such as an infrared, visible light, ultraviolet, X-ray, or electron ray. Such a material may be a radiation curable adhesive. The radiation curable adhesive contains a compound having a chemically modified radiation reactive functional group for adding radiation curability or a radiation curable compound (or radiation curable resin). Accordingly, the radiation curable adhesive preferably has a composition with a base material chemically modified with a radiation reactive functional group or a base material containing a radiation curable compound (or radiation curable resin).

The base material may be an adhesive substance such as a known pressure-sensitive bond (adhesive). Examples of the adhesive include: a rubber adhesive using as the base polymer a rubber-based polymer such as natural rubber, polyisobutylene rubber, styrene-butadiene rubber, styrene isoprene styrene block copolymer rubber, reclaimed rubber, butyl rubber, polyisobutylene rubber, and NBR; a silicone adhesive; and an acrylic adhesive. Among these, an acrylic adhesive is particularly preferable. The base material may includes one or more components.

The acrylic adhesive may be for example an acrylic adhesive using as the base polymer an acrylic polymer such as: a homopolymer or copolymer of alkyl (meth)acrylate ester such as C₁-C₂₀ alkyl (meth)acrylate ester such as methyl (meth)acrylate, ethyl (meth)acrylate, butyl (meth)acrylate, 2-ethylhexyl (meth)acrylate, and octyl (meth) acrylate; and a copolymer of the alkyl (meth)acrylate ester and other copolymerized monomer [for example a carboxyl group- or acid anhydride group-containing monomer such as acrylic acid, methacrylic acid, itaconic acid, fumaric acid, and maleic anhydride; a hydroxyl group-containing monomer such as 2-hydroxyethyl (meth)acrylate; an amino group-containing monomer such as morpholiyl (meth)acrylate; and an amido group-containing monomer such as (meth)acrylamide]. One of these substances or a combination of two or more of these substances can be used.

The radiation reactive functional group used for chemical modification for the curing radiation curable adhesive by radiation and the radiation curable compound are not limited to specific ones; they may be any functional group and compound that can be cured under irradiation with radiation such as infrared, visible light, ultraviolet, X-ray, or electron ray. Preferably, the functional group and the compound are such that the radiation curable adhesive after irradiation efficiently forms a three-dimensional network (net-like structure). One of or a combination of two or more of these types of radiation can be used. Examples of radiation reactive functional group used for the chemical modification include functional groups that have a carbon-carbon double bond, such as acryloyl group, methacryloyl group, vinyl group, allyl group, and acetylene group. The carbon-carbon double bonds in these functional groups cleave under irradiation with radiation to generate radicals. The radicals can act as cross-linking points to form a three-dimensional network structure. Among these, the (meth)acryloyl group is preferable in terms of reactivity and workability because the (meth)acryloyl group can exhibit relatively high reactivity to radiation and any of a wide variety of acrylic adhesives available can be chosen and used in combination.

An typical example of base material chemically modified with a radiation reactive functional group is a polymer produced by causing a compound [such as (meth)acryloyl oxyethylene isocyanate] having in a molecule a group (such as isocyanate group or epoxy group) that reacts with a reactive functional group and a radiation reactive functional group (such as acryloyl group or methacryloyl group) to react with a reactive functional group-containing acrylic polymer produced by copolymerizing a monomer [such as (2-hydroxyethyl (meth)acrylate or (meth)acrylate)] containing the reactive functional group such as a hydroxyl group or a hydroxyl group with alkyl (meth)acrylate ester.

The percentage of the monomer containing a reactive functional group in the reactive functional group-containing acrylic polymer is for example 5 to 40 wt%, preferably 10 to 30 wt% for the all monomers. The content of the compound having in molecule a group that reacts with the reactive functional group and the radiation reactive functional group for the reaction with the reactive functional group-containing acrylic polymer is for example 50 to 100 mol%, preferably 60 to 95 mol% based on the reactive functional groups (hydroxyl group, carboxyl group, and the like) in the reactive functional group-containing acrylic polymer.

Examples of radiation curable compound include a compound having two or more carbon-carbon double bonds, such as a poly(meth)acryloyl group-containing compound such as: trimethylol propane triacrylate, tetramethylol methane tetraacrylate, pentaerythritol triacrylate, pentaerythritol tetraacrylate, dipentaerythritol monohydroxy pentaacrylate, dipentaerythritol hexaacrylate, 1,4-butane diol diacrylate, 1,6-hexane diol diacrylate, and polyethylene glycol diacrylate. These compounds may be used singly or in combinations of two or more. Among them, a poly(meth)acryloyl group-containing compound is preferable and examples thereof are provided, for example in Japanese Patent Laid-Open No. 2003-292916. Hereinafter, a poly(meth)acryloyl group-containing compound is sometimes referred to as an "acrylate cross-linking agent".

Alternatively, the radiation curable compound may be a mixture of an organic salt such as onium salt and a compound having multiple heterocyclic rings in molecule. The organic salt in the mixture cleaves under irradiation with radiation to generate ions, which can act as an initiator to cause ring-opening reaction of the heterocyclic rings to form a three-dimensional network structure. Examples of the organic salt include iodonium salt, phosphonium salt, antimonium salt, sulfonium salt, and borate salt. Examples of the heterocyclic rings in the compound having multiple heterocyclic rings in molecule include oxirane, oxetane, oxolane, thiirane, and aziridine. Specifically, compounds contained in "Light Cure Technology" (2000) edited by Technical Information Institute can be used.

Examples of radiation curable resin include photosensitive reactive group-containing polymer and oligomer such as ester (meth)acrylate having a (meth)acryloyl group at an end of the molecule, urethane (meth)acrylate, epoxy (meth)acrylate, melamine (meth)acrylate, acrylic resin (meth)acrylate, thiol-ene addition resin having an allyl group at an end of the molecule, cationically photopolymerizable resin, cinnamoyl group-containing polymer such as polyvinyl cinnamate, diazotized amino novolac resin, and acrylamide polymer. Examples of polymers that react with high-energy radiation include epoxidized polybutadiene, unsaturated polyester, polyglycidyl methacrylate, polyacrylamide, and polyvinyl siloxane. If energy radiation curable resin is used, the base material is not necessarily required.

A particularly preferable radiation curable adhesive is a combination of any of the acrylic polymers given above or acrylic polymers chemically modified with a radiation reactive functional group (acrylic polymers having a radiation reactive functional group attached to a side chain) and any of the radiation curable compound (such as a compound having two or more carbon-carbon double bonds). The combination is preferable in terms of reactivity and workability because it contains an acrylate group exhibiting relatively high reactivity with radiation and can be selected from a wide variety of acrylic adhesives. Examples of such a combination include a combination of an acrylic polymer having an acrylate group attached to a side chain and a compound having two or more functional groups (in particular acrylate groups) having carbon-carbon double bonds. Such combinations may be those disclosed in Japanese Patent Laid-Open No. 2003-292916.

One method for preparing the acrylic polymer having an acrylate group attached to a side chain is to link an isocyanato compound such as acryloyl oxyethyl isocyanato or methacryloyloxy ethyl isocyanato with an acrylic polymer containing a hydroxyl group at a side chain through a urethane link.

The content of the radiation curable compound is approximately in the range of 0.5 to 200 pts.wt., preferably 5 to 180 pts.wt., more preferably 20 to 130 pts.wt. for 100 pts.wt. of the base material (for example any of the aforementioned acrylic polymers or acrylic polymers chemically modified with radiation reactive functional group), for example.

A radiation polymerization initiator for curing a compound that adds radiation curability may be added to the radiation curable adhesive in order to accelerate the reaction for forming the three-dimensional network structure.

The radiation polymerization initiator can be chosen from known or commonly used polymerization initiators appropriate for the type of radiation used (such as infrared rays, visible light, ultraviolet rays, X-rays, or electron rays). A compound capable of initiating photopolymerization with ultraviolet rays is preferable in terms of working efficiency. Typical examples of radiation polymerization initiator include, but not limited to, ketone initiators such as benzophenone, acetophenone, quinone, naphthoquinone, anthraquinone, and fluorenone; azo initiators such as
azobisisobutyronitrile; peroxide initiators such as benzoyl peroxide and perbenzoic acid. Commercially available initiators include initiators available under the trade designation "IRGACURE 184" and "IRGACURE 651" from Ciba-Geigy Ltd.

A single radiation polymerization initiator or a mixture of two or more radiation polymerization initiators can be used. The content of the radiation polymerization initiator is typically approximately in the range of 0.01 to 10 pts.wt., preferably approximately in the range of 1 to 8 pts.wt., for 100 pts.wt. of the base material. A radiation polymerization accelerator may be used in conjunction with the radiation polymerization initiator as required.

In addition to the components given above, appropriate additives may be added to the radiation curable adhesive, such as a cross-linking agent, a cure (cross-linking) accelerator, a tackifier, a vulcanizing agent, a thickener for providing appropriate adhesion before and after curing by irradiation with radiation, and anti-aging agent and antioxidizing agent for enhancing durability, as needed.

Examples of preferable radiation curable adhesive include a composition in which a radiation curable compound is added to a base material (adhesive), preferably a UV curable adhesive in which a UV curable compound is added to an acrylic adhesive. A particularly preferable radiation curable adhesive is a UV curable adhesive that contains a side-chain-acrylate-containing acrylic adhesive, an acrylate cross-linking agent (poly(meth)acryloyl group-containing compound or polyfunctional acrylate), and UV photopolymerization initiator. The side-chain-acrylate-containing acrylic adhesive is an acrylic polymer having an acrylate group attached to a side chain, which is a similar to the one described above and can be prepared in the same way described above. The acrylate cross-linking agent is any of the low-molecular compounds enumerated above as poly(meth)acryloyl group-containing compounds. The UV polymerization initiator may be any of the typical radiation polymerization initiators enumerated above.

A non-radiation-curable adhesive having any of the aforementioned acrylic adhesives as the base material may be used as the adhesive of the adhesive/bond layer 6. In that case, an adhesive that has adhesivity smaller than peel stress caused when the cylindrical roll is formed can be used. An example of adhesive that can be used is one that exhibits adhesivity of 6.5 N/10 mm or less (for example 0.05 to 6.5 N/10 mm, preferably 0.2 to 6.5 N/10 mm), in particular 6.0 N/10 mm or less (for example, 0.05 to 6.0 N/10 mm, preferably 0.2 to 6.0 N/10 mm) in a 180°-peeling test (at room temperature (25°C)) using a silicon mirror wafer as the adherend.

Examples of such non-radiation-curable adhesive including an acrylic having low adhesivity as the base material include an acrylic adhesive produced by adding a cross-linking agent that is reactive with a reactive functional group [such as an isocyanate cross-linking agent, a melamine cross-linking agent, or an epoxy cross-linking agent] to a copolymer of alkyl (meth)acrylate ester [for example, alkyl C₁-C₂₀ acrylate ester such as methyl (meth)acrylate, ethyl (meth)acrylate, butyl (meth)acrylate, 2-ethylhexyl (meth)acrylate, or octyl (meth)acrylate], a reactive functional group-containing monomer [for example, a carboxyl group- or acid anhydride group-containing monomer such as acrylic acid, methacrylic acid, itaconic acid, fumaric acid, and maleic anhydride; a hydroxyl group-containing monomer such as 2-hydroxyethyl (meth)acrylate; an amino group-containing monomer such as morpholiyl (meth)acrylate; or an amido group-containing monomer such as (meth)acrylamide], and another copolymerized monomer used as required [for example, alicyclic hydrocarbon radical-containing (meth)acrylic acid ester such as isobornyl (meth)acrylate or acrylonitrile] to cause cross-linking.

The adhesive/bond layer 6 can be formed using a commonly used method such as a method in which the surface of the non-thermally shrinkable base material 4 is coated with a coating agent containing an adhesive, a radiation curable compound and an optionally added solvent, or a method in which an appropriate release liner (separator) is coated with the aforementioned coating agent to form an adhesive layer, which is then transferred (adhered) onto the non-thermally shrinkable base material 4. In the case of transfer, voids can be left at the interface with the non-thermally shrinkable base material 4. In that case, pressurized steam can be applied using a method such as autoclave treatment to diffuse and eliminate the voids. The adhesive/bond layer 6 may be a single layer or a multilayer.

The adhesive/bond layer 6 in the present invention may further contain beads such as glass or resin beads. Addition of glass or resin beads advantageously increases the shear elasticity of the adhesive/bond layer 6 to facilitate reduction of adhesivity. The average diameter of the beads is for example 1 to 100 µm, preferably 1 to 20 µm. The quantity of beads added is for example 25 to 200 pts.wt., preferably 50 to 100 pts.wt., for 100 pts.wt. of the entire adhesive/bond layer 6. A quantity of added beads in any of the ranges given above does not cause non-uniform distribution of beads and does not make application of the adhesive difficult.

The thickness of the adhesive/bond layer 6 is typically 10 to 200 µm, preferably 20 to 100 µm, more preferably 30 to 60 µm. If the adhesive/bond layer 6 is too thin, the adhesive/bond layer 6 cannot provide a sufficiently high adhesivity and therefore cannot hold and temporarily fix an adherend. If the adhesive/bond layer 6 is made too thick, it is uneconomical and makes the adhesive/bond layer 6 hard to handle.

The self-rolling laminated sheet of the present invention can be manufactured by stacking, in sequence, the thermally shrinkable base material 2, the adhesive resin layer 3 and the non-thermally shrinkable base material 4 and laminating them using laminating means such as a hand roller or laminator or atmospheric pressure compressing means such as an autoclave selected appropriately for the purpose. The adhesive/bonding sheet of the present invention can be manufactured by disposing the adhesive/bond layer 6 on the surface of the non-thermally shrinkable base material 4 of the self-rolling laminated sheet, or laminating the non-thermally shrinkable base material 4 having the adhesive/bond layer 6 disposed on one surface beforehand together with the thermally shrinkable base material 2 with the adhesive resin layer 3 between them.

The adhesive/bonding sheet 5 of the present invention can be used as a protective adhesive/bonding sheet for semiconductor devices or an adhesive/bonding sheet for fixing a semiconductor wafer, for example. More specifically, the adhesive/bonding sheet 5 can be used as an adhesive sheet for silicon semiconductor backgrinding, compound semiconductor back grinding, silicon semiconductor dicing, compound semiconductor dicing, semiconductor package dicing, glass dicing, and ceramics dicing, for example. The adhesive/bonding sheet 5 is especially useful as an adhesive/bonding sheet for semiconductor devices, such as a protective adhesive/bonding sheet for semiconductor devices or an adhesive/bonding sheet for fixing a semiconductor wafer.

A method for working on an adherend using the adhesive/bonding sheet of the present invention will be described below. The adhesive/bonding sheet of the present invention is adhered and temporarily fixed to an adherend and required work is applied to the adherend (workpiece). Then the adhesivity of the adhesive/bond layer of the adhesive/bonding sheet is reduced and a stimulus that triggers shrinkage of the thermally shrinkable base member, such as heat, is applied to the adhesive/bonding sheet to cause the adhesive/bonding sheet to automatically roll up from one end of the adhesive/bonding sheet in one direction (normally in the primary shrinkage axis direction) or from two opposing ends toward the center of the adhesive/bonding sheet (normally in the primary shrinkage axis direction) into one or two cylinders, thereby peeling the adhesive/boding sheet off the adherend to provide a worked piece. If the adhesive/bonding sheet rolls up from one end in one direction, one cylinder is formed (unidirectional roll peeling); if the adhesive/bonding sheet automatically rolls up from two opposing ends toward its center, two parallel cylinders are formed (bidirectional roll peeling).

A typical example of workpiece is a semiconductor wafer. Examples of work include grinding, cutting, polishing, etching, lathe work, and heating only (at a temperature below the heat shrinkage start temperature if the shrinkable base material is shrinkable by heat). The use of the adhesive/bonding sheet is not limited to these types of work; the adhesive/bonding sheet can be used in any work that can be applied using the adhesive/bonding sheet.

After completion of the work on the workpiece, the adhesive/bond layer is irradiated with radiation if the adhesive/bond layer is radiation-curable, and the thermally shrinkable base material is heated with appropriate heating means. As a result, the adhesive/bond layer hardens and loses the adhesivity and the thermally shrinkable base material starts shrinking deformation. Accordingly, an edge (or two opposing edges) of the adhesive/bonding sheet is lifted and the adhesive/bonding sheet rolls up in one direction (or two opposing directions (toward its center)) by itself from the edge or edges into one cylinder (or two cylinders). In the roll-up, the shrinkage direction of the adhesive/bonding sheet is controlled by the non-thermally shrinkable base material and therefore the adhesive/bonding sheet unidirectionally quickly rolls into a cylinder or cylinders. Accordingly, the adhesive/bonding sheet can be very easily and neatly removed from the adherend (workpiece). An appropriate heating temperature can be chosen according to the shrink properties of the thermally shrinkable base material. For example, the heating temperature is 70 to 180°C, preferably 70 to 140°C. The irradiation with radiation and heating may be performed at the same time or in sequence. Heat may be uniformly applied over the entire surface of the adherend at a time or applied to the entire surface of the adherend stepwise, or only to a part of the surface to just trigger peeling. An appropriate heating method should be chosen to take advantage of the ease of peeling.

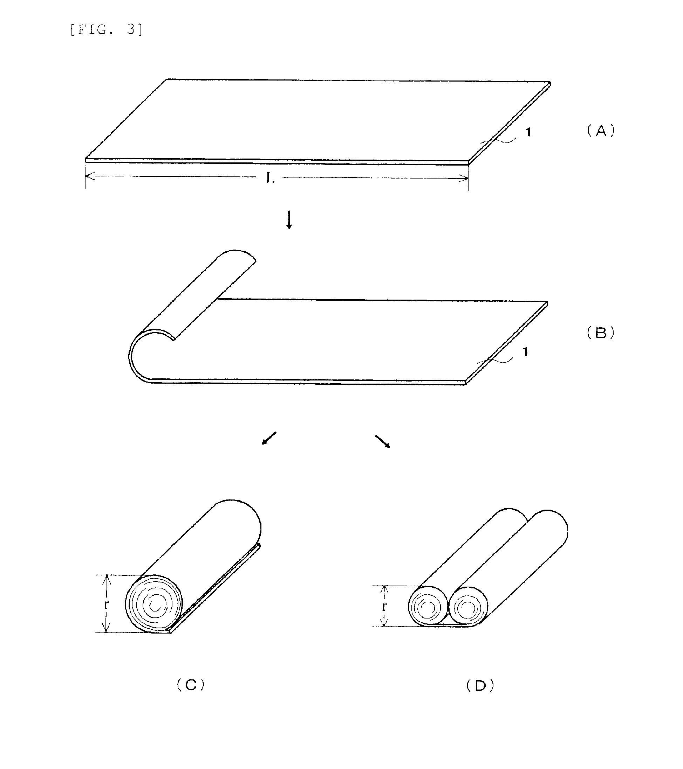

FIG. 3 is a diagram (perspective view) illustrating how a film or an adhesive/bonding sheet of the present invention rolls up into a cylinder. Part (A) illustrates the film or adhesive/bonding sheet before application of a stimulus that triggers shrinkage of the shrinkable film; part (B) illustrates the film or adhesive/bonding sheet (the adhesive/bonding sheet after the adhesivity of the adhesive layer decreased or was lost) starting to roll up from an edge (one end) of the sheet in one direction (normally in the primary shrinkage axis direction of the shrinkable film) upon application of the stimulus that triggers shrinkage of the thermally shrinkable base material; part (C) illustrates the sheet that has rolled up to form one cylinder (unidirectional rolling); and (D) illustrates the sheet that has automatically rolled up from two opposing ends of the sheet to the center (normally in the primary shrinkage axis direction of the shrinkable film) to form two cylinders (bidirectional rolling). The change of the shape of the film and the change of the shape of the adhesive/bonding sheet on which the adhesive/bond layer is provided are practically the same. Whether the film or the adhesive/bonding sheet rolls up in one direction or two directions depends on factors such as adhesivity of the non-thermally shrinkable base material to the thermally shrinkable base material and the shear elasticity of the non-thermally shrinkable base material (in particular the adhesive resin layer).

In FIG. 3, L indicates the length (or the diameter, if the sheet is circular) of the film or adhesive/bonding sheet 5 in the direction of rolling (normally, in the primary shrinkage axis direction of the thermally shrinkable base material) (FIG. 3(A)), r indicates the diameter of the cylinder formed (the maximum diameter if the diameter of the cylinder varies along the length of the cylinder as in a circular sheet) (FIGS. 3 (C) and 3(D)). The value of r/L in the film or the adhesive/bonding sheet of the present invention is preferably in the range of 0.001 to 0.333, more preferably 0.01 to 0.2, where L is for example 10 to 2000 mm, preferably 300 to 1000 mm. The length of the film or the adhesive/bonding sheet in the direction perpendicular to the length L is for example 10 to 2000 mm, preferably approximately in the range of 300 to 1000 mm. The value of r/L can be controlled so as to fall within any of the ranges given above by choosing or adjusting types of the materials, compositions, and thicknesses of the thermally shrinkable base material 2, the non-thermally shrinkable base material 4, the adhesive resin layer 3, and the adhesive/bond layer 6, in particular the shear elasticity and thickness of the adhesive resin layer 3 making up the non-thermally shrinkable base material 4 and the Young's modulus and thickness of the non-thermally shrinkable base material 4. In this example, the film or the adhesive/bonding sheet is rectangular in shape. However, any appropriate shape can be chosen, such as circular, elliptical, or polygonal, according to the purpose.

The use of the adhesive/bonding sheet of the present invention in work on an adherend (workpiece) prevents damage to the workpiece due to stress caused during peeling of the adhesive/bonding sheet. For example, in the case of work on a fragile adherend such as a thin semiconductor wafer, the adhesive/bonding sheet can be easily peeled off the adherend without damaging or soiling the adherend.

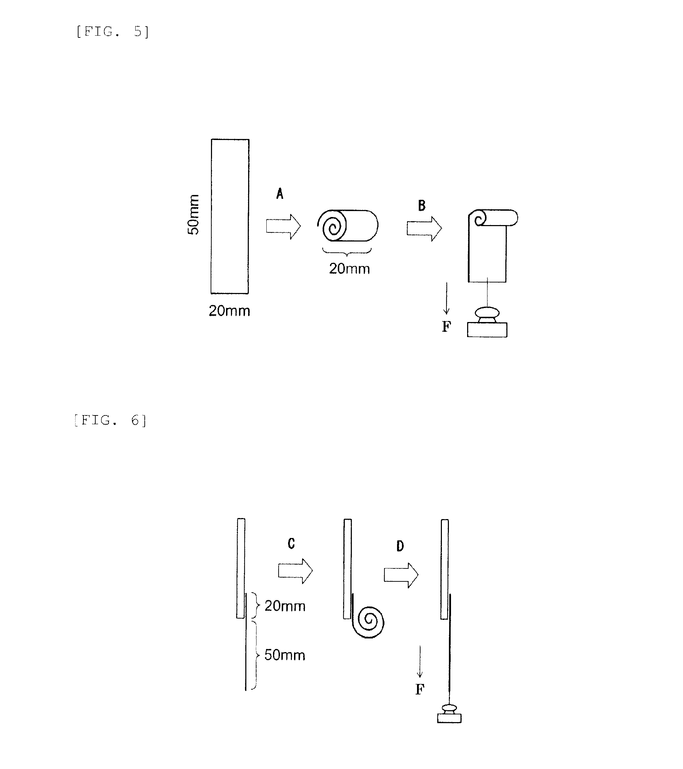

According to the present invention, the film and adhesive/bonding sheet are made of any of the materials given above and have the layer configuration including a thermally shrinkable base material, an adhesive resin layer, and a non-thermally shrinkable base material stacked in sequence. The film and the adhesive/bonding sheet also need to have the property of not automatically returning to the original shape after change into a cylindrical roll by heating.
To check the property, the film is cut to a length of 50 mm and a width of 20 mm, for example, as illustrated in FIG. 5. If the force F required for rolling out the cylindrical roll formed by heating the film at step A to the original length of 50 mm at step B exceeds 0.01 N, it can be reliably determined that the film changed into the cylindrical roll does not automatically return to the original state.
This is because the force required for rolling out the cylindrical roll, which behaves like a mainspring, depends on the rigidity of the cylindrical roll. If the force required for rolling out exceeds 0.01 N, the rolled film has a high rigidity. For example, when the film adhered to an adherend and caused to change into a cylindrical roll is pressed by stress applied during peeling/removal of the film, the film is not compressed to a degree that the cylindrical shape deforms and easily reattaches to the adherend. If the film reattaches, the film recovers from deformation because of its high rigidity (elasticity) and the reattached part peels off to facilitate removal. If the force is greater than or equal to 0.05 N, a harder cylindrical roll can be formed.
While the film is 50 mm long and 20 mm wide in the foregoing, the values are illustrative only and do not limit the dimensions of the film.
Of course, the force required for the film to roll out to the original length is not limited to 0.01 N since the required force varies with the size of the film.

As a physical property of the film of the present invention that does not automatically return to its original shape after the change into a cylindrical roll, the Young's modulus of the thermally shrinkable base material multiplied by its thickness may be 42000 N/m or greater, preferably 80000 N/m or greater. This is because the rigidity of the material making up of the stacked resin layer needs to be high in order for the film to be strong as a mainspring.
The thermally shrinkable base material is typically produced by biaxial-stretching and accordingly is anisotropic in the film plane (Young's modulus of the thermally shrinkable base material in the vertical direction of the film differs from that in the horizontal direction). According to the present invention, the Young's modulus in either vertical or horizontal direction, whichever is higher, can be used.

If the load required for the diameter of the film cut into a piece of 10 × 10 mm and heated to change into a cylindrical roll to become 1/2 of the initial diameter (L) of the film before applying the load is greater than or equal to 1 N, the rolled film is robust against external stress and is sufficiently hard enough for the film to be peeled/removed. If the load is greater than or equal to 1.2 N, the film has more reliable hardness for peeling/removal.

Advantageous effects of the present invention will be described below based on Examples.

### [Example 1]

As shown in Table 1, SPACECLEAN S7200 (with a thickness of 30 µm and a Young's modulus multiplied by thickness of 102000 N/m) from Toyobo was used as the thermally shrinkable base material. A non-thermally shrinkable base material, LUMIRROR S105 (38 µm thick) from Toray, was laminated with the thermally shrinkable base material with an adhesive resin layer made of a polyester polyol adhesive between them to make a laminated film.

### [Example 2]

A film was made in the same way as in Example 1, except that the non-thermally shrinkable base material was LUMIRROR E10 (12 µm thick).

### [Example 3]

A film was made in the same way as in Example 1, except that the adhesive resin layer made of an acrylic adhesive was used.

### [Example 4]

TORAYFAN 8D-YK51 from Toray (with a thickness of 8 µm and a Young's modulus multiplied by thickness of 28000 N/m) from Toray was used as the thermally shrinkable base material. A non-thermally shrinkable base material, LUMIRROR E55 (25 µm thick) from Toray, was laminated with the thermally shrinkable base material with an adhesive resin layer made of a polyester polyol adhesive between them to make a laminated film.

### (Test 1)

Each of the films of the Examples 1 to 4 was cut into a piece that is 20 mm wide and 70 mm long.
As illustrated in FIG. 6, a 20-mm-long end portion of the length of 70-mm was adhered to a sample-supporting plate (a 1-mm-thick SUS plate) by using a double-faced pressure-sensitive adhesive tape. The portion that was not adhered to the supporting plate was heated to cause the film to change into a cylindrical roll at step C.
Then, at step D, a weight was attached to the free end of the cylindrical roll and the load that restored the film to the initial shape before heating was measured. In Examples 1 to 3, the loads F required were 0.07 N or greater whereas in Example 4 the load F required was 0.01 N.

### (Test 2)

The films of Examples 1 to 4 were cut into 10 × 10 mm and heated to cause them to change into cylindrical rolls. Loads were applied to the cylindrical rolls to compress the cylindrical rolls and the load required for the height (L') of the cylindrical roll to decrease to 1/2 of the initial diameter (L) of the cylindrical roll was measured.
The loads required were 1 N or greater in Examples 1 to 3 whereas in Example 4 the load required was 0.05 N, which was measuring limit or below.
The result showed that the cylindrical roll of the film that required a force greater than or equal to 0.01 N to roll out was resistant to deformation under an external stress.

### (Test 3)

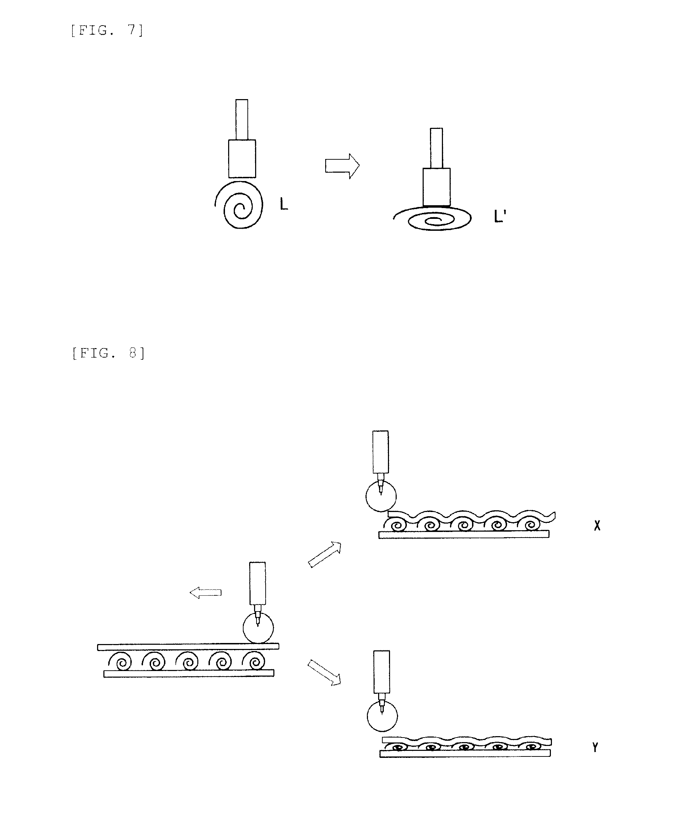

An acrylic adhesive was applied to the non-thermally shrinkable base material of each of the films of Examples 1 to 4 to make an adhesive sheet. The adhesive sheet was cut into a piece of 10 × 10 mm and then heated to change into a cylindrical roll.
The cylindrical roll of film was attached to a glass plate and forces of 10 to 15 N was applied to the sheet with the measuring device used in test 2 to compress the cylindrical roll as flat as possible to attach tightly (adhere) the adhesive layer onto the glass plate.
Then, the time required for the sheet to return to the original cylindrical roll it took before the compression due to rigid (elastic) recovery of the stacked base materials while the adhered area was decreasing was measured. If the time required for the film to return to the shape indicated by X in FIG. 8 was less than or equal to 1 minute, the film was judged as ○; if the film remained compressed after 1 or more minutes passed as indicated by Y in FIG. 8, the film was judged as ×.
The adhesive sheets of Examples 1 to 3 using the stacked base materials started to return to the original shape upon release of the load and returned to the original shape within 1 minute whereas the adhesive sheet obtained from the film of Example 4 remained adhered and did not return to the original shape. This showed that the cylindrical roll that required a force of 0.01 N or greater for rolling out could be readily peeled off simply by removing the force, even if the cylindrical roll reattached to the adherend because of peeling operation stress.

### (Test 4)

Assuming that an adhesive/bonding sheet according to the present invention is used for protecting the surface of a wafer during dicing, a test described below was conducted to determine the usefulness of the adhesive sheet.
Each of the four types of adhesive sheets from the films of Examples 1 to 4 made in test 3 was cut into 25 pieces of 10 × 10 mm. The cut pieces were heated to cause them to change into cylindrical rolls. The 25 rolls were evenly arranged on a glass plate of 5 × 5 cm.
To remove the 25 cylindrical rolls from the glass plate, a 50-mm-wide backgrinding tape removal tape (BT-315 from Nitto Denko Corporation) was placed on the cylindrical rolls and a metal pad (8 cm in diameter) was pressed against BT-315 from above as illustrated in FIG. 8 to ensure that BT-315 adhere to the cylindrical rolls. After the rolls were sufficiently pressed, the pad was removed and BT-315 was peeled off. As a result, all of the 25 cylindrical roles of the adhesive sheets from the films of Examples 1 to 3 were successfully removed. In contrast, the rolls of adhesive sheet of Example 4 sufficiently pressed were not peeled off because a part of BT-315 also adhered to the glass plate. When the rolls were pressed with a reduced pressure so that BT-315 did not adhere to the glass plate, only 20 of the cylindrical rolls, at maximum, were removed because the adhesion between the cylindrical rolls and BT-315 was insufficient. It was therefore judged that the adhesive sheet from the tape of Example 4 was not practical.

The results of tests 1 to 4 showed that it is ensured that the films and adhesive/bonding sheets of the present invention can be peeled and removed after they adhered to the surface of an adherend and rolled into cylinders because they have the property of rolling up into a cylindrical roll that does not automatically return to the original shape after heating, compared with adhesive bonding sheets that do not have such a property.

**[Table 1]**

| | Thermally shrinkable base material | Young's modulus multiplied by thickness of thermally shrinkable base material (Nm-1) | Adhesive resin layer | Non-thermally shrinkable base material | Test 1 | Test 2 | Test 3 | Test 4 |
|---|---|---|---|---|---|---|---|---|
| Example 1 | SPACECLEAN S7200 from Toyobo (30 µm) | 102000 | Polyester polyol adhesive | LUMIRROR S105 from Toray (38 µm) | 0.07 | 1.3 | ○ | All samples were removed |
| Example 2 | Ditto | Ditto | Polyester polyol adhesive | LUMIRROR E10 from Toray (12 µm) | 0.07 | 1.2 | ○ | All samples were removed |
| Example 3 | Ditto | Ditto | Acrylic adhesive | LUMIRROR S105 from Toray (38 µm) | 0.1 | 1.5 | ○ | All samples were removed |
| Example 4 | TORAYFAN 8D-YK51 from Toray (8 µm) | 28000 | Polyester polyol adhesive | LUMIRROR E55 from Toray (25 µm) | 0.01 | 0.05 or less | × | Not removable |

### Description of Symbols

1 Film
2 Thermally shrinkable base material
3 Adhesive resin layer
4 Non-thermally shrinkable base material
5 Adhesive/bonding sheet
6 Adhesive/bond layer

## Claims

1. A film comprising, a thermally shrinkable base material, an adhesive resin layer, and a non-thermally shrinkable base material stacked in sequence, wherein the film has the property of changing its shape into a cylindrical roll by heating and not automatically returning to an original shape after the change into the cylindrical roll.

2. The film according to claim 1, wherein the thermally shrinkable base material is a stretched material selected from the group consisting of polyesters, polyolefins, and polyamides and the non-thermally shrinkable base material is a material having thermal dimensional stability improved by processing such as stretching orientation fixing, the non-thermally shrinkable material being selected from the group consisting of polyesters, polyolefins, polyimides and polyamides.

3. The film according to claim 1 or 2, wherein the thermally shrinkable base material exhibits a Young's modulus multiplied by thickness of the thermally shrinkable base material equal to or higher than 42000 N/m at room temperature.

4. The film according to claim 2, wherein the thermally shrinkable base material is a polyethylene terephthalate film or a polybutylene phthalate film subjected to stretching and the non-thermally shrinkable base material is a polyethylene terephthalate resin film subjected to thermal dimensional stability improving processing.

5. The film according to any one of claims 1 to 4, wherein the adhesive resin layer is made of an adhesive including a polymer polymerized from an acrylic monomer or a bond including a polyester polyol.

6. An adhesive/bonding sheet comprising an adhesive/bond layer provided on a surface of the non-thermally shrinkable base material of the film according to any one of claims 1 to 5 for adhering to any adherend.

7. A film or adhesive/bonding sheet according to any one of claims 1 to 6, wherein the external force required for returning the film or adhesive/bonding sheet cut into a piece of 50 x 20 mm and then changed into a cylindrical roll by heating to its original shape is greater than or equal to 0.01 N.

## Amended claims

### Amended claims in accordance with Rule 137(2) EPC.

**1.** A film comprising a thermally shrinkable base material, which has a product of a Young's modulus and a thickness of 42000 N/m or higher at room temperature, an adhesive resin layer including a polyester polyol, and a non-thermally shrinkable base material stacked in sequence, wherein the film has the property of changing its shape into a cylindrical roll by heating and not automatically returning to an original shape after the change into the cylindrical roll.

**2.** The film according to claim 1, wherein the thermally shrinkable base material is a stretched material selected from the group consisting of polyesters, polyolefins, and polyamides and the non-thermally shrinkable base material is a material having thermal dimensional stability improved by processing such as stretching orientation fixing, the non-thermally shrinkable material being selected from the group consisting of polyesters, polyolefins, polyimides and polyamides.

**3.** The film according to claim 2, wherein the thermally shrinkable base material is a polyethylene terephthalate film or a polybutylene phthalate film subjected to stretching and the non-thermally shrinkable base material is a polyethylene terephthalate resin film subjected to thermal dimensional stability improving processing.

**4.** An adhesive/bonding sheet comprising an adhesive/bond layer provided on a surface of the non-thermally shrinkable base material of the film according to any one of claims 1 to 3 for adhering to any adherent.

**5.** A film or adhesive/bonding sheet according to any one of claims 1 to 4, wherein the external force required for returning the film or adhesive/bonding sheet cut into a piece of 50 x 20 mm and then changed into a cylindrical roll by heating to its original shape is greater than or equal to 0.01 N.
